# DEMANDE DE BREVET EUROPEEN

(11) **EP 4 553 901 A1**
(43) Date de publication de la demande: **14.05.2025**
(21) Numéro de dépôt: 24210975.9
(22) Date de dépôt: 05.11.2024
(51) Int. Cl.: H01L 25/07, H02M 1/14, H02M 7/493, H02M 7/00

(54) **MODULE ÉLECTRONIQUE DE PUISSANCE**

(30) Priorité: 08.11.2023 FR 2312134
(71) Demandeur: Safran Electrical & Power, 31702 Blagnac (FR)
(72) Inventeur: ALAWIEH, Hadi, 77550 MOISSY-CRAMAYEL (FR); BIAUJAUD, Rémy, 77550 MOISSY-CRAMAYEL (FR)
(74) Mandataire: Ernest Gutmann - Yves Plasseraud S.A.S.

(57) **Abrégé**

La présente divulgation concerne un module électronique de puissance (1) comprenant au moins deux cellules de commutation (2a,2b) s'étendant chacun en parallèle entre un conducteur positif (3) et un conducteur négatif (4) d'un bus continu, chacune des cellules de commutation (2a,2b) comprenant un dispositif de commutation haut (21a,21b) et un dispositif de commutation bas (22a,22b),
dans lequel le conducteur positif (3), le conducteur négatif (4) et leur raccordement respectivement aux dispositifs de commutation haut (21a,21b) et bas (22a,22b) sont conformés tridimensionnellement de sorte que, pour deux cellules de commutation (2a,2b) consécutives, un champ magnétique engendré par une circulation de courant dans les conducteurs positif et négatif et l'une des deux cellules de commutation (2a) présente un sens opposé à un champ magnétique engendré par une circulation de courant dans les conducteurs positif et négatif et l'autre des deux cellules de commutation (2b).

## Description

### Domaine technique

La présente divulgation relève du domaine des modules électroniques de puissance pour la conversion d'énergie électrique. De tels modules sont notamment destinés à l'alimentation en puissance d'un équipement électrique, en particulier dans le domaine de l'aéronautique.

### Technique antérieure

De manière générale, un module électronique de puissance comprend des composants électroniques de puissance qui permettent d'alimenter en énergie un équipement électrique à partir d'un réseau électrique, notamment par l'intermédiaire de conducteurs électriques sous la forme de bus. A cette fin, les composants électroniques de puissance comportent des puces semi-conductrices formant des dispositifs de commutation, tels que par exemple des transistors semiconducteurs, qui sont commandés par une unité électronique de contrôle.

D'un point de vue structurel, un module électronique de puissance comporte classiquement un substrat, les composants électroniques de puissance montés sur le substrat et des moyens de connexion électrique des composants électroniques de puissance aux conducteurs électriques. Le tout est classiquement encapsulé dans un boîtier et noyé dans un matériau d'encapsulation, tel que de la résine.

De manière générale, les différents éléments du module électronique de puissance qui sont traversés par un courant électrique sont à l'origine d'une inductance parasite qui s'oppose à la variation de courant. Cette inductance parasite peut induire une surtension au niveau des dispositifs de commutation lors de leur ouverture et de leur fermeture. Cette surtension conditionne alors le dimensionnement des dispositifs de commutation, car il faut s'assurer qu'en fonctionnement les dispositifs de commutation n'atteignent pas leur tension de claquage. Il existe donc un besoin de limiter les inductances parasites dans le module électronique de puissance.

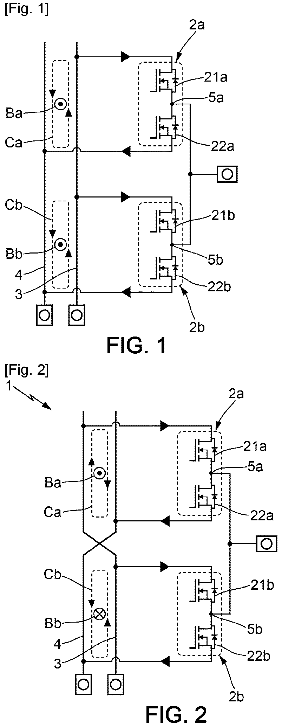

Les problématiques liées à cette inductance parasite sont davantage développées ci-après en référence à la figure 1. La figure 1 représente un schéma électrique d'un exemple de module électronique de puissance pour un convertisseur de puissance. Ce convertisseur de puissance comprend deux cellules de commutation 2a, 2b formant un bras de commutation et s'étendant chacune en parallèle entre un conducteur positif 3 et un conducteur négatif 4 d'un bus continu. Le conducteur positif 3 et le conducteur négatif 4 présentent respectivement un potentiel positif DC+ et un potentiel négatif DC-. Le bus continu formé par le conducteur positif et le conducteur négatif alimente les cellules de commutation de façon monotone.

Chaque cellule de commutation 2a, 2b comprend un dispositif de commutation haut 21a, 21b et un dispositif de commutation bas 22a, 22b. Le dispositif de commutation haut 21a, 21b est électriquement connecté, d'une part, au conducteur positif 3 et, d'autre part, à une sortie 5a, 5b, aussi désignée phase, et le dispositif de commutation bas 22a, 22b est électriquement connecté, d'une part, au conducteur négatif 4 et, d'autre part, à la sortie 5a, 5b. Autrement dit, la sortie 5a, 5b est agencée entre le dispositif de commutation haut 21a, 21b et le dispositif de commutation bas 22a, 22b.

Dans l'exemple illustré sur la figure 1, on désigne par boucle de commutation, une circulation du courant dans chacune des cellules de commutation et à l'interconnexion entre les conducteurs positif et négatif et la cellule de commutation correspondante. Cette boucle de commutation induit une inductance parasite qui correspond à l'addition d'inductances parasites élémentaires de chacun des éléments de la boucle de commutation. L'inductance parasite provient notamment du rebouclage du courant depuis le conducteur positif 3 vers le conducteur négatif 4.

De plus, l'agencement tridimensionnel du bus continu est généralement réalisé de sorte que les conducteurs positif et négatif sont placés l'un face à l'autre. Cet agencement du bus continu induit une concentration partielle de l'inductance parasite spatialement entre les conducteurs positif et négatif pour chacune des cellules de commutation. La boucle de commutation réduite à la circulation du courant spatialement entre les conducteurs positif et négatif est représentée sur la figure 1 par les références Ca et Cb correspondant respectivement à la boucle de commutation de l'une et de l'autre des deux cellules de commutation. Cette circulation du courant induit alors une inductance parasite correspondant à un champ magnétique Ba et Bb respectivement de chacune des deux cellules de commutation.

L'inductance parasite, due à la boucle de commutation réduite à la circulation du courant spatialement entre les conducteurs positif et négatif comme précédemment expliqué, induit une surtension au niveau des dispositifs de commutation lors de leur ouverture et de leur fermeture. Il existe un besoin de limiter cette surtension de sorte à permettre la mise en oeuvre de dispositifs de commutation présentant une tension nominale de fonctionnement proche de la tension de claquage.

### Résumé

La présente divulgation vient améliorer la situation.

Il est proposé un module électronique de puissance comprenant au moins deux cellules de commutation s'étendant chacun en parallèle entre un conducteur positif et un conducteur négatif d'un bus continu. Lesdites au moins deux cellules de commutation forment notamment un bras de commutation. Chacune des cellules de commutation comprend un dispositif de commutation haut électriquement connecté, d'une part, au conducteur positif et, d'autre part, à une sortie de la cellule de commutation correspondante, et un dispositif de commutation bas électriquement connecté, d'une part, au conducteur négatif et, d'autre part, à la sortie de la cellule de commutation correspondante. Le conducteur positif, le conducteur négatif et leur raccordement respectivement aux dispositifs de commutation haut et bas sont conformés tridimensionnellement de sorte que, pour deux cellules de commutation consécutives, un champ magnétique engendré par une circulation de courant dans les conducteurs positif et négatif et l'une des deux cellules de commutation présente un sens opposé à un champ magnétique engendré par une circulation de courant dans les conducteurs positif et négatif et l'autre des deux cellules de commutation.

La sortie de chacune des cellules de commutation est notamment désignée phase.

On entend par champ magnétique engendré par une circulation de courant dans les conducteurs positif et négatif et l'une des deux cellules de commutation, un champ magnétique correspondant à une inductance parasite s'opposant à une circulation du courant dans les conducteurs positif et négatif et la cellule de commutation correspondante, et notamment à l'interconnexion entre les conducteurs positif et négatif et la cellule de commutation. En particulier, le champ magnétique est engendré par une circulation du courant spatialement entre les conducteurs positif et négatif pour chacune des cellules de commutation.

On entend par sens de champ magnétique, un sens de circulation des lignes de champs du champ magnétique correspondant.

On entend par, le conducteur positif, le conducteur négatif et leur raccordement respectivement aux dispositifs de commutation haut et bas sont conformés tridimensionnellement, que les conducteurs positif et négatif et le raccordement respectivement du conducteur positif au dispositif de commutation haut et du conducteur négatif au dispositif de commutation bas sont agencés dans l'espace de sorte à obtenir une compensation au moins partielle du champ magnétique entre deux cellules de commutation consécutifs.

La conformation des conducteurs positif et négatif et de leur raccordement respectif aux dispositifs de commutation, de manière à obtenir un champ magnétique sensiblement opposé pour deux cellules de commutation consécutives, permet avantageusement la compensation, au moins partielle, des inductances parasites ainsi créées dans les cellules de commutation consécutives.

On désigne par boucle de commutation, une circulation du courant dans chacune des cellules de commutation et à l'interconnexion entre les conducteurs positif et négatif et la cellule de commutation correspondante. La présente divulgation, en mettant en oeuvre un sens de circulation de courant opposé dans chaque boucle de commutation de deux cellules de commutation consécutives, permet ainsi de compenser, au moins partiellement les inductances parasites des boucles de commutation. Autrement dit, la présente divulgation permet de limiter les inductances parasites dans le module électronique de puissance, notamment engendrées par une circulation de courant dans les conducteurs positif et négatif.

Limiter ces inductances parasites permet avantageusement de réduire une surtension lors de l'ouverture et de la fermeture des dispositifs de commutation. Il est alors possible de mettre en oeuvre donc des dispositifs de commutation présentant un écart réduit entre la tension de claquage et la tension nominale du dispositif de commutation en question. Ceci permet en conséquence d'augmenter la fréquence de commutation des dispositifs de commutation et donc d'en améliorer les performances en diminuant les pertes par commutation. De plus, réduire les surtensions permet de restreindre le bruit électromagnétique généré par les dispositifs de commutation.

Les caractéristiques exposées dans les paragraphes suivants peuvent, optionnellement, être mises en oeuvre, indépendamment les unes des autres ou en combinaison les unes avec les autres :

Avantageusement, chacun des dispositifs de commutation comporte une ou plusieurs puces semi-conductrices montées en parallèle. Cette configuration permet de faciliter le dimensionnement et la mise en oeuvre dans le module électronique de puissance des dispositifs de commutation.

Le module électronique de puissance peut comprendre deux cellules de commutation ou plus de deux cellules de commutation, par exemple trois cellules de commutation. Pour chaque couple de deux cellules de commutation consécutives, le conducteur positif, le conducteur négatif et leur raccordement respectivement aux dispositifs de commutation haut et bas peuvent alors être conformés tridimensionnellement de sorte qu'un champ magnétique engendré par une circulation de courant dans les conducteurs positif et négatif et l'une des deux cellules de commutation présente un sens opposé à un champ magnétique engendré par une circulation de courant dans les conducteurs positif et négatif et l'autre des deux cellules de commutation.

Par ailleurs, les sorties de chacun des cellules de commutation peuvent être interconnectées entre elles.

De manière avantageuse, le module électronique de puissance comprend une carte électronique s'étendant selon un plan. La carte électronique peut notamment comporter un circuit imprimé. La carte électronique comprend ladite au moins deux cellules de commutation agencées consécutivement l'une à l'autre selon une première direction du plan de la carte électronique. La carte électronique comprend, pour chacune des cellules de commutation, une première piste connectant électriquement le conducteur positif et le dispositif de commutation haut de la cellule de commutation correspondante et une deuxième piste connectant électriquement le conducteur négatif et le dispositif de commutation bas de la cellule de commutation correspondante.

Le conducteur positif et le conducteur négatif s'étendent avantageusement selon la première direction au-dessus de la carte électronique.

La carte électronique peut comprendre en outre, pour chacune des cellules de commutation, une troisième piste électriquement connectée à la sortie de la cellule de commutation correspondante. La troisième piste peut notamment être réalisée d'un tenant et être électriquement connectée aux sorties de toutes les cellules de commutation. Autrement dit, les sorties de toutes les cellules de commutation sont reliées électriquement entre elles par l'intermédiaire de la troisième piste. Mutualiser ainsi la troisième piste pour toutes les cellules de commutation permet de faciliter la mise en oeuvre et le montage du module électronique de puissance.

Pour chacune des cellules de commutation, le dispositif de commutation haut peut être monté sur la première piste et être électriquement connecté à la troisième piste, par exemple par l'intermédiaire de fils électriques. De plus, pour chacune des cellules de commutation, le dispositif de commutation bas peut être monté sur la troisième piste et être électriquement connecté à la deuxième piste, par exemple par l'intermédiaire de fils électriques.

Le conducteur positif comprend avantageusement une barre et, pour chacune des cellules de commutation, au moins une patte de connexion s'étendant depuis la barre. Une extrémité de la patte de connexion opposée à la barre est connectée électriquement à la première piste au niveau d'une zone de raccordement de la première piste. Le conducteur positif peut comprendre une seule ou plusieurs pattes de connexion pour chacune des cellules de commutation. Par exemple, le conducteur positif peut comprendre deux pattes de connexion par cellule de commutation.

De manière similaire, le conducteur négatif comprend avantageusement une barre et, pour chacune des cellules de commutation, au moins une patte de connexion s'étendant depuis la barre. Une extrémité de la patte de connexion opposée à la barre est connectée électriquement à la deuxième piste au niveau d'une zone de raccordement de la deuxième piste. Le conducteur négatif peut comprendre une seule ou plusieurs pattes de connexion pour chacune des cellules de commutation. Par exemple, le conducteur négatif peut comprendre deux pattes de connexion par cellule de commutation.

La carte électronique peut comprendre, pour chacune des cellules de commutation, une unique première piste, la ou les pattes de connexion étant toutes connectées à la même unique première piste. Alternativement, la carte électronique peut comprendre, pour chacune des cellules de commutation, une pluralité de premières pistes. Chaque première piste de la pluralité de premières pistes peut notamment être connectée à une patte de connexion correspondante lorsque le conducteur positif comprend plusieurs pattes de connexion.

De manière similaire, la carte électronique peut comprendre, pour chacune des cellules de commutation, une unique deuxième piste, la ou les pattes de connexion étant toutes connectées à la même unique deuxième piste. Alternativement, la carte électronique peut comprendre, pour chacune des cellules de commutation, une pluralité de deuxièmes pistes. Chaque deuxième piste de la pluralité de deuxièmes pistes peut notamment être connectée à une patte de connexion correspondante lorsque le conducteur négatif comprend plusieurs pattes de connexion.

Il convient de noter que la première piste et la deuxième piste peuvent respectivement comprendre une ou plusieurs zones de raccordement. Le nombre de zones de raccordement par cellule de commutation correspond notamment au nombre de pattes de connexion par cellule de commutation.

De manière avantageuse, la zone de raccordement de la première piste et la zone de raccordement de la deuxième piste de l'une des deux cellules de commutation consécutives sont agencées inversement de la zone de raccordement de la première piste et de la zone de raccordement de la deuxième piste de l'autre des deux cellules de commutation selon une deuxième direction dans le plan de la carte électronique. Cette caractéristique permet avantageusement d'intervertir selon la deuxième direction le raccordement aux conducteurs positif et négatif des dispositifs de commutation des deux cellules de commutation consécutives. Cette interversion des zones de raccordement permet avantageusement de réaliser la conformation tridimensionnelle du conducteur positif, du conducteur négatif et de leur raccordement respectivement aux dispositifs de commutation haut et bas pour deux cellules de commutation consécutives, de sorte qu'un champ magnétique engendré par une circulation de courant dans les conducteurs positif et négatif et l'une des deux cellules de commutation présente un sens opposé à un champ magnétique engendré par une circulation de courant dans les conducteurs positif et négatif et l'autre des deux cellules de commutation.

Ladite deuxième direction est de préférence sensiblement perpendiculaire à la première direction.

Les premières pistes et les deuxièmes pistes respectivement de chacune des cellules de commutation peuvent avantageusement présenter un même agencement sur la carte électronique mais en étant décalées selon la première direction. Cette configuration spatiale permet avantageusement de faciliter la mise en oeuvre du module électronique de puissance. En effet, cette configuration permet de pouvoir adapter facilement le positionnement de zones de raccordement aux pattes de connexion.

De manière avantageuse, la barre du conducteur positif et la barre du conducteur négatif s'étendent sensiblement selon une troisième direction perpendiculaire au plan de la carte électronique.

La barre du conducteur positif et la barre du conducteur négatif sont avantageusement agencées de manière à se croiser entre les deux cellules de commutation consécutives, notamment au niveau d'une zone de croisement. Ce croisement des barres des conducteur positif et négatif permet avantageusement de mettre les barres des conducteurs positif et négatif en vis-à-vis selon la troisième direction des zones de raccordement interverties entre les deux cellules de commutation consécutives et donc de permettre la mise en oeuvre de cette interversion. On entend par se croiser que le conducteur positif et le conducteur négatif sont agencés de manière à être intervertis, en particulier selon ladite deuxième direction, entre les deux cellules de commutation consécutives. Il convient de noter que ce croisement n'implique pas que les conducteurs positif et négatif entrent en contact l'un avec l'autre mais uniquement que leur positionnement tridimensionnel est interverti entre les des deux cellules de commutation consécutives.

Les conducteurs positif et négatif peuvent notamment être agencés de manière à passer l'un au-dessus de l'autre selon la troisième direction.

Plus précisément, les barres respectivement des conducteurs positif et négatif peuvent présenter une largeur selon la troisième direction réduite dans la zone de croisement des conducteurs positif et négatif. Ainsi, les barres des conducteurs positif et négatif peuvent passer l'une au-dessus de l'autre selon la troisième direction sans impacter l'encombrement des conducteurs selon la troisième direction.

L'une de la barre du conducteur positif ou de la barre du conducteur négatif peut être agencée de manière à contourner l'autre de la barre du conducteur positif ou de la barre du conducteur négatif, notamment au niveau d'une zone de contournement. Ce contournement des barres des conducteur positif et négatif permet avantageusement de mettre les barres des conducteurs positif et négatif en vis-à-vis selon la troisième direction des zones de raccordement interverties entre les deux cellules de commutation consécutives et donc de permettre la mise en oeuvre de cette interversion. La zone de contournement peut notamment être agencée à une extrémité des barres selon la première direction.

Le conducteur positif et le conducteur négatif peuvent avantageusement être laminés ensemble et agencés sensiblement parallèlement au plan de la carte électronique. Une couche d'isolant électrique est notamment intercalée entre le conducteur positif et le conducteur négatif, plus précisément entre les barres respectivement du conducteur positif et du conducteur négatif. Le conducteur positif et le conducteur négatif sont agencés de sorte que chaque patte de connexion de l'un du conducteur positif ou du conducteur négatif traverse un orifice de la barre de l'autre du conducteur positif ou du conducteur négatif.

Avantageusement, le module électronique de puissance consiste en un module électronique de puissance pour aéronef.

Selon un autre aspect, il est proposé un convertisseur de puissance comprenant le module électronique de puissance, le convertisseur de puissance étant notamment un convertisseur de puissance alternatif/continu ou continu/continu.

### Brève description des dessins

D'autres caractéristiques, détails et avantages apparaîtront à la lecture de la description détaillée ci-après, et à l'analyse des dessins annexés, sur lesquels :
**Fig. 1**
   [Fig. 1] illustre schématiquement un exemple de circuit électrique d'un module électronique de puissance conventionnel.
**Fig. 2**
   [Fig. 2] illustre schématiquement un exemple de circuit électrique d'un module électronique de puissance selon un mode de réalisation.
**Fig. 3**

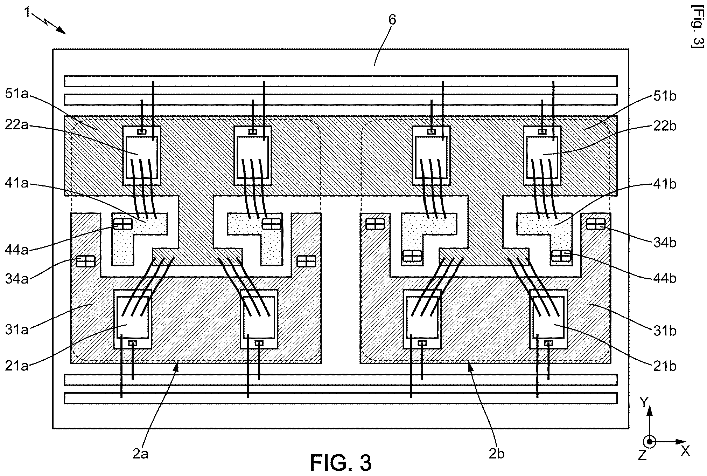

   [Fig. 3] illustre schématiquement une vue partielle d'un module électronique de puissance selon un mode de réalisation.
**Fig. 4**

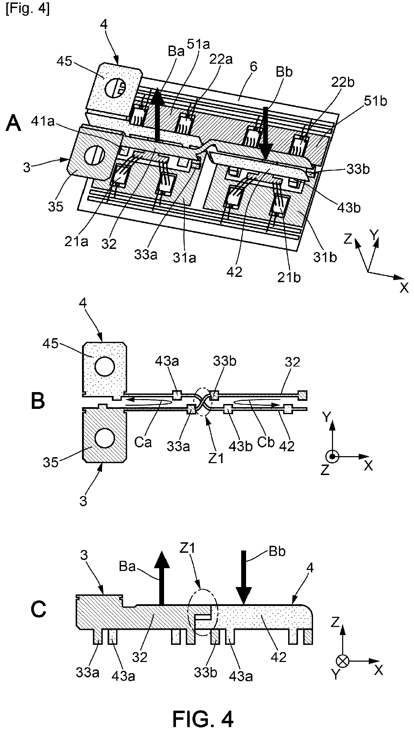

   [Fig. 4] illustre schématiquement trois vues partielles (Figures 4A, 4B et 4C) d'un module électronique de puissance selon un premier mode de réalisation.
**Fig. 5**

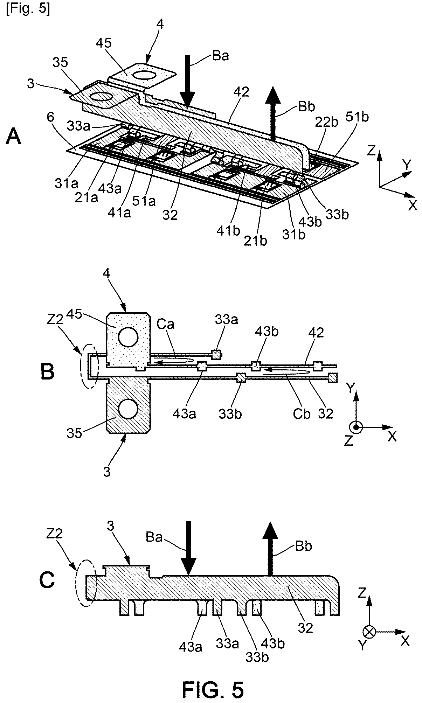

   [Fig. 5] illustre schématiquement trois vues partielles (Figures 5A, 5B et 5C) d'un module électronique de puissance selon un deuxième mode de réalisation.
**Fig. 6**

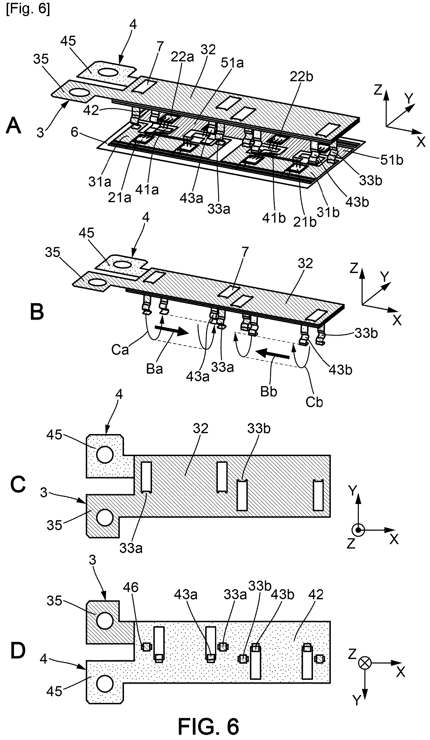

   [Fig. 6] illustre schématiquement quatre vues partielles (Figures 6A, 6B, 6C et 6D) d'un module électronique de puissance selon un troisième mode de réalisation.

### Description des modes de réalisation

Il est maintenant fait référence à la figure 2 illustrant un schéma électrique d'un module électronique de puissance 1, notamment pour aéronef. La présente divulgation concerne aussi un convertisseur de puissance comprenant le module électronique de puissance, le convertisseur de puissance étant notamment un convertisseur de puissance alternatif/continu ou continu/continu.

Le module de puissance 1 comprend au moins deux cellules de commutation 2a,2b s'étendant chacune en parallèle entre un conducteur positif 3 et un conducteur négatif 4 d'un bus continu. Lesdites au moins deux cellules de commutation forment notamment un bras de commutation. En particulier, le conducteur positif 3 et le conducteur négatif 4 présentent respectivement un potentiel positif DC+ et un potentiel négatif DC-, et le bus continu formé par le conducteur positif et le conducteur négatif alimente les cellules de commutation de façon monotone.

Le module électronique de puissance peut comprendre deux cellules de commutation ou plus de deux cellules de commutation, par exemple trois cellules de commutation. La configuration avec deux cellules de commutation sera utilisée ci-après à titre d'illustration. Il convient toutefois de noter que les éléments décrits pourront tout autant s'appliquer à une configuration avec plus de deux cellules de commutation.

Chacune des cellules de commutation 2a,2b comprend un dispositif de commutation haut 21a,21b électriquement connecté, d'une part, au conducteur positif 3 et, d'autre part, à une sortie 5a,5b de la cellule de commutation correspondante, et un dispositif de commutation bas 22a,22b électriquement connecté, d'une part, au conducteur négatif 4 et, d'autre part, à la sortie 5a,5b de la cellule de commutation correspondant. La sortie de chacune des cellules de commutation est notamment désignée phase. Les sorties de chacune des cellules de commutation peuvent être interconnectées entre elles.

Chacun des dispositifs de commutation comporte notamment une ou plusieurs puces semi-conductrices montées en parallèle. Cette configuration permet de faciliter le dimensionnement et la mise en oeuvre dans le module électronique de puissance des dispositifs de commutation.

Le conducteur positif 3, le conducteur négatif 4 et leur raccordement respectivement aux dispositifs de commutation haut 21a,21b et bas 22a,22b sont conformés tridimensionnellement de sorte que, pour deux cellules de commutation 2a,2b consécutives, un champ magnétique engendré par une circulation de courant dans les conducteurs positif et négatif et l'une des deux cellules de commutation 2a présente un sens opposé à un champ magnétique engendré par une circulation de courant dans les conducteurs positif et négatif et l'autre des deux cellules de commutation 2b.

En outre, lorsque le module électronique de puissance comprend plus de deux cellules de commutation, pour chaque couple de deux cellules de commutation consécutives, le conducteur positif, le conducteur négatif et leur raccordement respectivement aux dispositifs de commutation haut et bas peuvent avantageusement être conformés tridimensionnellement de sorte qu'un champ magnétique engendré par une circulation de courant dans les conducteurs positif et négatif et l'une des deux cellules de commutation présente un sens opposé à un champ magnétique engendré par une circulation de courant dans les conducteurs positif et négatif et l'autre des deux cellules de commutation.

En référence à la figure 2, on désigne par boucle de commutation, une circulation du courant dans chacune des cellules de commutation et à l'interconnexion entre les conducteurs positif et négatif et la cellule de commutation correspondante. Cette boucle de commutation induit une inductance parasite qui correspond à l'addition d'inductances parasites élémentaires de chacun des éléments de la boucle de commutation. La boucle de commutation réduite à la circulation du courant spatialement entre les conducteurs positif et négatif est représentée sur la figure 2 par les références Ca et Cb correspondant respectivement à la boucle de commutation de l'une et de l'autre des deux cellules de commutation. Cette circulation du courant induit alors une inductance parasite correspondant à un champ magnétique Ba et Bb respectivement de chacune des deux cellules de commutation.

La conformation des conducteurs positif et négatif et de leur raccordement respectif aux dispositifs de commutation, de manière à obtenir un champ magnétique sensiblement opposé pour deux cellules de commutation consécutives, permet avantageusement la compensation, au moins partielle, des inductances parasites ainsi créées dans les cellules de commutation consécutives. Autrement dit, la présente divulgation permet de limiter les inductances parasites dans le module électronique de puissance, notamment engendrées par une circulation de courant dans les conducteurs positif et négatif.

Limiter ces inductances parasites permet avantageusement de réduire une surtension lors de l'ouverture et de la fermeture des dispositifs de commutation. Il est alors possible de mettre en oeuvre donc des dispositifs de commutation présentant un écart réduit entre la tension de claquage et la tension nominale du dispositif de commutation en question. Ceci permet en conséquence d'augmenter la fréquence de commutation des dispositifs de commutation et donc d'en améliorer les performances en diminuant les pertes par commutation. De plus, réduire les surtensions permet de restreindre le bruit électromagnétique généré par les dispositifs de commutation.

En référence à la figure 3, le module électronique de puissance 1 comprend de préférence une carte électronique 6 s'étendant selon un plan XY. La carte électronique 6 comprend les deux cellules de commutation 2a,2b agencées consécutivement l'une à l'autre selon une première direction X du plan XY de la carte électronique 6. On définit une deuxième direction Y dans le plan XY de la carte électronique 6 qui est de préférence perpendiculaire à la première direction X, et une troisième direction Z perpendiculaire au plan XY de la carte électronique 6.

La carte électronique 6 comprend, pour chacune des cellules de commutation 2a,2b, une première piste 31a,31b connectant électriquement le conducteur positif 3 et le dispositif de commutation haut 21a,21b de la cellule de commutation correspondante et une deuxième piste 41a,41b connectant électriquement le conducteur négatif 4 et le dispositif de commutation bas 22a,22b de la cellule de commutation correspondante. Dans l'exemple illustré à la figure 3, chaque dispositif de commutation comporte deux puces semi-conductrices montées en parallèle.

La carte électronique 6 peut comprendre en outre, pour chacune des cellules de commutation 2a,2b, une troisième piste 51a,51b électriquement connectée à la sortie de la cellule de commutation correspondante. La troisième piste 51a,51b peut notamment être réalisée d'un tenant et être électriquement connectée aux sorties de toutes les cellules de commutation (comme illustré à la figure 3). Autrement dit, les sorties de toutes les cellules de commutation sont reliées électriquement entre elles par l'intermédiaire de la troisième piste. Mutualiser ainsi la troisième piste pour toutes les cellules de commutation permet de faciliter la mise en oeuvre et le montage du module électronique de puissance.

Pour chacune des cellules de commutation, le dispositif de commutation haut 21a, 21b peut être monté sur la première piste 31a, 31b et être électriquement connecté à la troisième piste 51a,51b, par exemple par l'intermédiaire de fils électriques. De plus, pour chacune des cellules de commutation, le dispositif de commutation bas 22a,22b peut être monté sur la troisième piste 51a,51b et être électriquement connecté à la deuxième piste 41a,41b, par exemple par l'intermédiaire de fils électriques.

La carte électronique 6 peut comprendre, pour chacune des cellules de commutation 2a,2b, une unique première piste 31a, 31b (comme illustré sur la figure 3). Alternativement, la carte électronique 6 peut comprendre, pour chacune des cellules de commutation 2a,2b, une pluralité de premières pistes (non illustré).

L'unique première piste 31a, 31b présente notamment une première partie destinée à recevoir le ou les puces électroniques du dispositif de commutation haut et une deuxième partie destinée à être électriquement connectée au conducteur positif. La première partie de la première piste peut présenter une forme de plaquette s'étendant dans le plan XY de la carte électronique et la deuxième partie de la première piste peut former une bande s'étendant dans le plan XY depuis la plaquette selon la deuxième direction Y.

De manière similaire, la carte électronique 6 peut comprendre, pour chacune des cellules de commutation, une unique deuxième piste 41a,41b (non illustré). Alternativement, la carte électronique 6 peut comprendre, pour chacune des cellules de commutation 2a,2b, une pluralité de deuxièmes pistes 41a, 41b. La figure 3 représente en particulier une configuration où la carte électronique comprend deux deuxièmes pistes 41a, 41b pour chacune des cellules de commutation.

Chaque deuxième piste 41a, 41b peut notamment comporter une première partie destinée à être électriquement connectée à la ou aux puces électroniques du dispositif de commutation bas et une deuxième partie destinée à être électriquement connectée au conducteur négatif. En particulier, la première partie de la deuxième piste peut former une bande s'étendant selon la première direction X de la carte électronique. La deuxième partie de la deuxième piste peut former une bande s'étendant selon la deuxième direction Y de la carte électronique 6 depuis une extrémité selon la première direction X de la première partie de la deuxième piste.

Il est maintenant fait référence aux figures 4, 5 et 6 représentants respectivement un premier, un deuxième et un troisième mode de réalisation de la présente divulgation. Le conducteur positif et le conducteur négatif s'étendent avantageusement selon la première direction X au-dessus de la carte électronique 6.

Le conducteur positif 3 comprend avantageusement une barre 32 et, pour chacune des cellules de commutation 2a,2b, au moins une patte de connexion 33a,33b s'étendant depuis la barre 32, notamment selon la troisième direction Z. Une extrémité de la patte de connexion 33a,33b opposée à la barre 32 est connectée électriquement à la première piste 31a,31b au niveau d'une zone de raccordement 34a,34b de la première piste 31a,31b. La zone de raccordement de la piste correspond à la zone où la patte de connexion est électriquement connectée à la piste et est illustrée sur la figure 3. Le conducteur positif 3 peut comprendre une seule ou plusieurs pattes de connexion pour chacune des cellules de commutation. Par exemple, le conducteur positif peut comprendre deux pattes de connexion 33a,33b par cellule de commutation, comme illustré aux figures 4, 5 et 6.

Pour chaque cellule de commutation, lorsque la carte électronique comprend une unique première piste, la ou les pattes de connexion peuvent être toutes connectées à la même unique première piste. Lorsque la carte électronique comprend, pour chacune des cellules de commutation, une pluralité de premières pistes, chaque première piste de la pluralité de premières pistes peut être connectée à l'une des pattes de connexion (non illustré).

Similairement, le conducteur négatif 4 comprend avantageusement une barre 42 et, pour chacune des cellules de commutation 2a,2b, au moins une patte de connexion 43a,43b s'étendant depuis la barre 42, notamment selon la troisième direction Z. Une extrémité de la patte de connexion 43a,43b opposée à la barre 42 est connectée électriquement à la deuxième piste 41a,41b au niveau d'une zone de raccordement 44a,44b de la deuxième piste 41a,41b. La zone de raccordement de la piste correspond à la zone où la patte de connexion est électriquement connectée à la piste et est illustrée sur la figure 3. Le conducteur négatif 4 peut comprendre une seule ou plusieurs pattes de connexion pour chacune des cellules de commutation. Par exemple, le conducteur négatif peut comprendre deux pattes de connexion 43a,43b par cellule de commutation, comme illustré aux figures 4, 5 et 6.

Pour chaque cellule de commutation, lorsque la carte électronique comprend une unique deuxième piste, la ou les pattes de connexion peuvent être toutes connectées à la même unique deuxième piste (non illustré). Lorsque la carte électronique comprend, pour chacune des cellules de commutation, une pluralité de deuxièmes pistes, chaque deuxième piste de la pluralité de deuxièmes pistes peut être connectée à l'une des pattes de connexion.

Il convient de noter que la première piste et la deuxième piste peuvent respectivement comprendre une ou plusieurs zones de raccordement. Le nombre de zones de raccordement par cellule de commutation correspond notamment au nombre de pattes de connexion par cellule de commutation.

Les premières pistes 31a,31b et les deuxièmes pistes 41a,41b respectivement de chacune des cellules de commutation 2a,2b peuvent avantageusement présenter un même agencement sur la carte électronique mais en étant décalées selon la première direction X. Cette configuration spatiale permet avantageusement de faciliter la mise en oeuvre du module électronique de puissance. En effet, cette configuration permet de pouvoir adapter facilement le positionnement de zones de raccordement aux pattes de connexion.

De manière avantageuse, la zone de raccordement 34a de la première piste 31a et la zone de raccordement 44a de la deuxième piste 41a de l'une des deux cellules de commutation 2a consécutives sont agencées inversement de la zone de raccordement 34b de la première piste 31b et de la zone de raccordement 44b de la deuxième piste 41b de l'autre des deux cellules de commutation 2b selon la deuxième direction Y dans le plan XY de la carte électronique 6. Cette caractéristique permet avantageusement d'intervertir selon la deuxième direction le raccordement aux conducteurs positif et négatif des dispositifs de commutation des deux cellules de commutation consécutives. Cette interversion des zones de raccordement permet avantageusement de réaliser la conformation tridimensionnelle du conducteur positif, du conducteur négatif et de leur raccordement respectivement aux dispositifs de commutation haut et bas pour deux cellules de commutation consécutives, de sorte qu'un champ magnétique engendré par une circulation de courant dans les conducteurs positif et négatif et l'une des deux cellules de commutation présente un sens opposé à un champ magnétique engendré par une circulation de courant dans les conducteurs positif et négatif et l'autre des deux cellules de commutation.

Il convient de noter que la réalisation de la carte électronique représentée à la figure 3 s'applique aux premier, deuxième et troisième modes de réalisation de la présente divulgation décrits ci-après.

Comme illustré aux figures 4A, 4B, 4C, 5A, 5B et 5C, la barre 32 du conducteur positif 3 et la barre 42 du conducteur négatif 4 peut avantageusement s'étendre sensiblement selon la troisième direction Z.

En référence aux figures 4A, 4B et 4C, selon le premier mode de réalisation, la barre 32 du conducteur positif 3 et la barre 42 du conducteur négatif 4 sont notamment agencées de manière à se croiser entre les deux cellules de commutation consécutives, notamment au niveau d'une zone de croisement Z1.

Ce croisement des barres des conducteurs positif et négatif permet avantageusement de mettre les barres des conducteurs positif et négatif en vis-à-vis selon la troisième direction Z des zones de raccordement interverties entre les deux cellules de commutation consécutives et donc de permettre la mise en oeuvre de cette interversion.

On entend par se croiser que le conducteur positif et le conducteur négatif sont agencés de manière à être intervertis, en particulier selon ladite deuxième direction Y, entre les deux cellules de commutation consécutives. Il convient de noter que ce croisement n'implique pas que les conducteurs positif et négatif entrent en contact l'un avec l'autre mais uniquement que leur positionnement tridimensionnel est interverti entre les des deux cellules de commutation consécutives.

La boucle de commutation réduite à la circulation du courant spatialement entre les conducteurs positif et négatif est représentée sur la figure 4B par les références Ca et Cb correspondant respectivement à la boucle de commutation de l'une et de l'autre des deux cellules de commutation. Cette circulation du courant induit alors une inductance parasite correspondant aux champs magnétiques Ba et Bb respectivement de chacune des deux cellules de commutation, représentés à la figure 4A. Les champs magnétiques Ba et Bb, étant orientés dans un sens opposé l'un à l'autre selon la troisième direction Z se compensent bien entre eux, au moins partiellement, de sorte à réduire l'inductance parasite de la boucle de commutation.

Les conducteurs positif 3 et négatif 4 peuvent notamment être agencés de manière à passer l'un au-dessus de l'autre selon la troisième direction Z.

Plus précisément, les barres 32,42 respectivement des conducteurs positif 3 et négatif 4 peuvent présenter une largeur selon la troisième direction Z réduite dans la zone de croisement Z1 des conducteurs positif et négatif. Ainsi, les barres des conducteurs positif et négatif peuvent passer l'une au-dessus de l'autre selon la troisième direction sans impacter l'encombrement des conducteurs selon la troisième direction Z.

En référence aux figures 5A, 5B et 5C, selon le deuxième mode de réalisation, l'une de la barre 32 du conducteur positif 3 ou de la barre 42 du conducteur négatif 4 est agencée de manière à contourner l'autre de la barre 32 du conducteur positif 3 ou de la barre 42 du conducteur négatif 4, notamment au niveau d'une zone de contournement Z2.

Ce contournement des barres des conducteur positif et négatif permet avantageusement de mettre les barres des conducteurs positif et négatif en vis-à-vis selon la troisième direction Z des zones de raccordement interverties entre les deux cellules de commutation consécutives et donc de permettre la mise en oeuvre de cette interversion.

La boucle de commutation réduite à la circulation du courant spatialement entre les conducteurs positif et négatif est représentée sur la figure 5B par les références Ca et Cb correspondant respectivement à la boucle de commutation de l'une et de l'autre des deux cellules de commutation. Cette circulation du courant induit alors une inductance parasite correspondant aux champs magnétiques Ba et Bb respectivement de chacune des deux cellules de commutation, représentés à la figure 5A. Les champs magnétiques Ba et Bb, étant orientés dans un sens opposé l'un à l'autre selon la troisième direction Z se compensent bien entre eux, au moins partiellement, de sorte à réduire l'inductance parasite de la boucle de commutation.

La zone de contournement Z2 peut notamment être agencée à une extrémité des barres selon la première direction X.

En référence aux figures 6A, 6B, 6C et 6D, selon le troisième mode de réalisation, le conducteur positif 3 et le conducteur négatif 4 sont avantageusement laminés ensemble et agencés sensiblement parallèlement au plan XY de la carte électronique 6.

Une couche d'isolant électrique 7 est notamment intercalée entre le conducteur positif et le conducteur négatif, plus précisément entre les barres 32,42 respectivement du conducteur positif 3 et du conducteur négatif 4.

En particulier, le conducteur positif 3 et le conducteur négatif 4 sont agencés de sorte que chaque patte de connexion 33a,33b,43a,43b de l'un du conducteur positif 3 ou du conducteur négatif 4 traverse un orifice 46 de la barre 32,42 de l'autre du conducteur positif 3 ou du conducteur négatif 4.

La boucle de commutation réduite à la circulation du courant spatialement entre les conducteurs positif et négatif est représentée sur la figure 6B par les références Ca et Cb correspondant respectivement à la boucle de commutation de l'une et de l'autre des deux cellules de commutation. Cette circulation du courant induit alors une inductance parasite correspondant aux champs magnétiques Ba et Bb respectivement de chacune des deux cellules de commutation, représentés également à la figure 5B. Les champs magnétiques Ba et Bb, étant orientés dans un sens opposé l'un à l'autre selon la première direction X se compensent bien entre eux, au moins partiellement, de sorte à réduire l'inductance parasite de la boucle de commutation.

## Revendications

1. Module électronique de puissance (1) comprenant au moins deux cellules de commutation (2a,2b) s'étendant chacun en parallèle entre un conducteur positif (3) et un conducteur négatif (4) d'un bus continu, chacune des cellules de commutation (2a,2b) comprenant :
- un dispositif de commutation haut (21a,21b) électriquement connecté, d'une part, au conducteur positif (3) et, d'autre part, à une sortie (5a,5b) de la cellule de commutation correspondante, et
- un dispositif de commutation bas (22a,22b) électriquement connecté, d'une part, au conducteur négatif (4) et, d'autre part, à la sortie (5a,5b) de la cellule de commutation correspondant,
dans lequel le conducteur positif (3), le conducteur négatif (4) et leur raccordement respectivement aux dispositifs de commutation haut (21a,21b) et bas (22a,22b) sont conformés tridimensionnellement de sorte que, pour deux cellules de commutation (2a,2b) consécutives, un champ magnétique engendré par une circulation de courant dans les conducteurs positif et négatif et l'une des deux cellules de commutation (2a) présente un sens opposé à un champ magnétique engendré par une circulation de courant dans les conducteurs positif et négatif et l'autre des deux cellules de commutation (2b),
le module électronique de puissance (1) comprenant une carte électronique (6) s'étendant selon un plan (XY) et comprenant lesdites au moins deux cellules de commutation (2a,2b) agencées consécutivement l'une à l'autre selon une première direction (X) du plan (XY) de la carte électronique (6),
la carte électronique (6) comprenant, pour chacune des cellules de commutation (2a,2b), :
- une première piste (31a,31b) connectant électriquement le conducteur positif (3) et le dispositif de commutation haut (21a,21b) de la cellule de commutation correspondante,
- une deuxième piste (41a,41b) connectant électriquement le conducteur négatif (4) et le dispositif de commutation bas (22a,22b) de la cellule de commutation correspondante,
le conducteur positif (3) comprenant une barre (32) et, pour chacune des cellules de commutation (2a,2b), au moins une patte de connexion (33a,33b) s'étendant depuis la barre (32), une extrémité de la patte de connexion (33a,33b) opposée à la barre (32) étant connectée électriquement à la première piste (31a,31b) au niveau d'une zone de raccordement (34a,34b) de la première piste (31a,31b),
le conducteur négatif (4) comprenant une barre (42) et, pour chacune des cellules de commutation (2a,2b), au moins une patte de connexion (43a,43b) s'étendant depuis la barre (42), une extrémité de la patte de connexion (43a,43b) opposée à la barre (42) étant connectée électriquement à la deuxième piste (41a,41b) au niveau d'une zone de raccordement (44a,44b) de la deuxième piste (41a,41b),
la barre (32) du conducteur positif (3) et la barre (42) du conducteur négatif (4) sont agencées de manière à se croiser entre les deux cellules de commutation consécutives.

2. Module électronique de puissance (1) selon la revendication précédente, dans lequel la carte électronique (6) comprend en outre, pour chacune des cellules de commutation (2a,2b), une troisième piste (51a,51b) électriquement connectée à la sortie (5a,5b) de la cellule de commutation correspondante.

3. Module électronique de puissance (1) selon la revendication 1 ou 2, dans lequel la zone de raccordement (34a) de la première piste (31a) et la zone de raccordement (44a) de la deuxième piste (41a) de l'une des deux cellules de commutation (2a) consécutives sont agencées inversement de la zone de raccordement (34b) de la première piste (31b) et de la zone de raccordement (44b) de la deuxième piste (41b) de l'autre des deux cellules de commutation (2b) selon une deuxième direction (Y) dans le plan (XY) de la carte électronique (6).

4. Module électronique de puissance (1) selon la revendication précédente, dans lequel ladite deuxième direction (Y) est sensiblement perpendiculaire à la première direction (X).

5. Module électronique de puissance (1) selon l'une des revendications 1 à 4, dans lequel la barre (32) du conducteur positif (3) et la barre (42) du conducteur négatif (4) s'étendent sensiblement selon une troisième direction (Z) perpendiculaire au plan (XY) de la carte électronique (6).

6. Module électronique de puissance (1) selon l'une des revendications 1 à 5, dans lequel l'une de la barre (32) du conducteur positif (3) ou de la barre (42) du conducteur négatif (4) est agencée de manière à contourner l'autre de la barre (32) du conducteur positif (3) ou de la barre (42) du conducteur négatif (4).

7. Module électronique de puissance (1) selon l'une des revendications 1 à 5, dans lequel le conducteur positif (3) et le conducteur négatif (4) sont laminés ensemble et agencés sensiblement parallèlement au plan (XY) de la carte électronique (6),
le conducteur positif (3) et le conducteur négatif (4) étant agencés de sorte que chaque patte de connexion (33a,33b,43a,43b) de l'un du conducteur positif (3) ou du conducteur négatif (4) traverse un orifice (46) de la barre (32,42) de l'autre du conducteur positif (3) ou du conducteur négatif (4).
